# EUROPEAN PATENT SPECIFICATION

(11) **EP 2 136 411 B1**
(45) Date of publication and mention of the grant of the patent: **31.08.2011**
(21) Application number: 09157373.3
(22) Date of filing: 06.04.2009
(51) Int. Cl.: H01L 31/042, H01L 31/05

(54) **Antitheft and monitoring system for photovoltaic panels**
Antidiebstahl- und Überwachungssystem für Solarpaneele
Système antivol et de surveillance pour panneaux photovoltaïques

(30) Priority: 11.06.2008 EP 08425415
(43) Date of publication of application: 23.12.2009
(73) Proprietor: SAVIO S.p.A., 10050 Chiusa San Michele (Torino) (IT)
(72) Inventor: Balbo Di Vinadio, Aimone, I-10050, Chiusa San Michele (Torino) (IT); Palazzetti, Mario, I-10050, Chiusa San Michele (Torino) (IT)
(74) Representative: Marchitelli, Mauro

(56) References cited:
- WO-A-97/42664
- WO-A-2004/090993
- WO-A-2007/048421
- WO-A-2008/062076
- US-A1- 2004 216 777
- US-A1- 2005 224 109

## Description

The present invention relates to an antitheft and monitoring system for photovoltaic panels.

Photovoltaic technology has witnessed a considerable expansion in the last few years; in particular, it is very advantageous in remote areas, where said technology has always occupied a strategic role for the distributed generation of electrical energy. However, since they are in the majority of cases sites that are not presided over, they are exposed to a high risk of theft of the photovoltaic panels.

The idea of providing an antitheft system that will prevent operation of the photovoltaic panel when this is detached from the supply line is known, for example, from the international patent publication No. WO 97/42664.

This document describes an antitheft device for photovoltaic panels connected by means of a connection line to a distribution line. In particular, the antitheft device comprises a first unit, associated to the distribution line, and a second unit, associated to the panel. The first unit is designed to generate an activation code, and the second unit is designed to inhibit operation of the panel in the absence of said activation code.

In photovoltaic plants with a high number of panels, there arises the need to have available a monitoring function that will enable identification of the panels that present an anomalous behaviour in order to programme interventions of cleaning and/or replacement thereof.

The object of the present invention is to provide an antitheft system that will also enable monitoring of photovoltaic panels and will be simple, reliable, and inexpensive.

According to the present invention, said object is achieved by a monitoring system having the characteristics that form the subject of Claim 1. The present invention also regards a corresponding procedure as recited in claim 12.

The present invention advantageously exploits the characteristics of the antitheft device to provide also the monitoring function. In this way, i.e., re-using the hardware already installed, the possibility of performing the operations of monitoring and diagnostics is achieved without requiring installation of a dedicated system.

The antitheft device can be applied to any photovoltaic panel, for example during its processing step (lamination), and this excludes any possibility of tampering with or removal of the antitheft device, without damaging the photovoltaic panel irreparably.

As will emerge clearly from the ensuing description, by appropriately managing an antitheft system that inhibits operation of the panels in the absence of an activation code it is possible to carry out monitoring of a photovoltaic field.

One of the main characteristics of the present invention lies precisely in the combination of the functions of antitheft device and monitoring system. Said functions use the same hardware as regards the panels and centralized hardware for the monitoring, which is in turn used for driving the inverter that connects the field of photovoltaic panels to the electric-power mains. The monitoring hardware could also have on board a GPS system for preventing theft of the panels that are combined to the inverter.

Further characteristics and advantages of the invention will emerge from the ensuing description with reference to the annexed drawings, which are provided purely by way of non-limiting example and in which:
- Figure 1 shows an example of photovoltaic plant equipped with an antitheft device;
- Figure 2 shows an example of positioning of the antitheft device within a photovoltaic panel;
- Figure 3 shows in detail the connection of the antitheft device between the cells that form the photovoltaic panel;
- Figure 4 is a cross-sectional view of a portion of panel;
- Figure 5 shows an example of architecture of the monitoring system;
- Figure 6 shows in detail the field of panels of Figure 5; and
- Figures 7, 8 and 9 show three different embodiments of the monitoring system.

Described in detail in the first part of the description is operation of the antitheft device. Described, instead, in the second part of the description is operation of the monitoring system that uses the aforesaid antitheft device for the purposes of diagnostics of the individual panels that make up the photovoltaic plant.

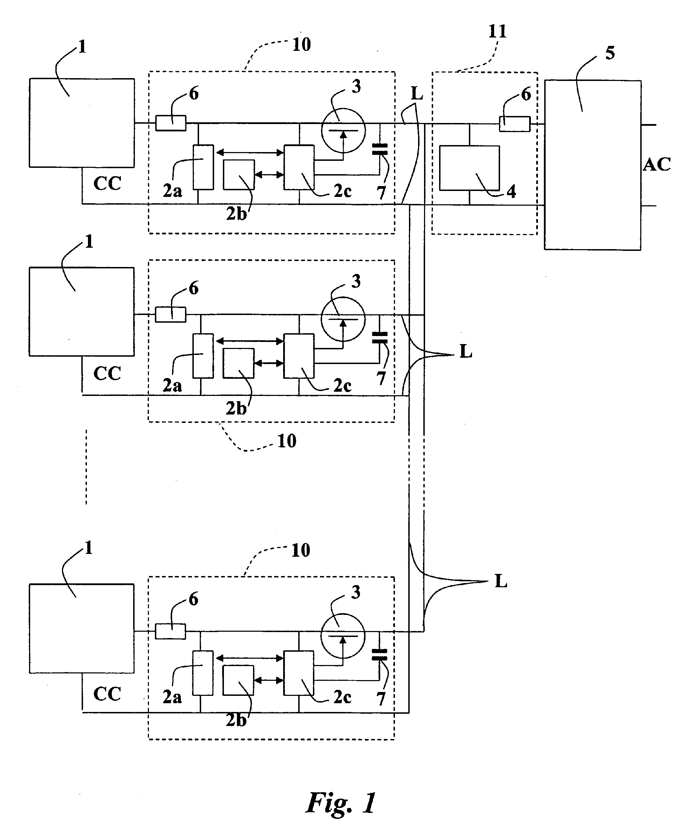

With reference to Figure 1, an antitheft device for photovoltaic panels 1 connected by means of a connection line L to a distribution substation 5 comprises a first unit 11, associated to the distribution substation 5, and a plurality of second units 10, associated to the panels 1. The first unit 11 is designed to generate an activation code 4 and each of the second units 10 is designed to inhibit operation of the respective panel 1 in the absence of the activation code 4.

Once again with reference to Figure 1, a plurality of photovoltaic panels 1 are connected in parallel to the two conductors of a connection line, designated as a whole by L, to form a photovoltaic plant.

The energy produced by a photovoltaic panel 1 is in the form of d.c. current CC. To transform the d.c. current CC into a.c. current AC it is necessary to introduce into the plant an inverter device, designated by the reference number 5 in Figure 1. In all the cases where d.c. current CC is usable directly, the inverter is not present. In the sequel of the text, however, we shall continue to refer to the inverter to indicate a circuit site in which the unit 4 will be inserted.

The antitheft device used comprises a first unit 11 associated to the distribution substation 5 on the plant side, and a plurality of second units 10 associated to the panels 1.

The first unit 11 comprises a code generator 4, which generates an activation code and with pre-set cadence sends it onto the conductors of the connection line L, and an inductance 6 that serves to prevent the high-frequency signal generated by the code generator 4 from propagating downstream of the inverter 5 and upstream of the panels 1.

Once again with reference to Figure 1, an example of embodiment of the second unit 10 comprises a counter 2a, a memory element 2b, a logic unit 2c, and a switch 3. There are moreover present an inductance 6, which serves to prevent the signal generated by the code generator 4 from propagating to the photovoltaic panel 1, and a capacitor 7, which serves to carry the high-frequency signal generated by the code generator 4 to the logic unit 2c.

The memory element 2b stores inside it a copy of the activation code for decoding using the code that arrives on the connection line L. The memory element 2b is preferably a ROM (Read-Only Memory), and the activation code can be written and personalized by the user during installation or in the factory, which will have to communicate the code to the user.

The counter 2a, inside each panel 1, serves to mark the wait time of the activation code.

The code generator 4 sends, at periodic intervals, the activation code on the line L. The logic unit 2c processes the code stored using the activation code present on the connection line L to activate the switch 3. The logic unit 2c is configured for resetting the counter 2a in the case of positive outcome of the decoding operation.

In the case of negative outcome of the decoding operation, the counter 2b is not reset by the logic unit 2c and continues to count until it reaches a pre-set configuration. This situation arises, for example, when the panel is taken away from the plant and does not receive the activation code within the pre-set wait time. At this point, the logic unit 2c issues a command for opening of the switch 3 to deactivate operation of the respective panel 1. The switch 3 can, for example, be a FET (Field-Effect Transistor).

Hence, each second unit 10 inhibits operation of the respective panel 1 in the absence of the activation code 4 for a pre-set period.

The activation code does not have to be particularly complex but must ensure security so as to speed up the step of decoding performed by the logic unit 2c and limit costs. The activation code is not always present on the connection line L but is sent thereon by the code generator 4 with a pre-set cadence. The code will be encrypted in such a way that it will be difficult to decode.

The second units 10, which together with the first unit 11 perform the function of antitheft device, are associated to the panels. The second units 10 can be external or else, for greater security, can be integrated within the photovoltaic panels themselves.

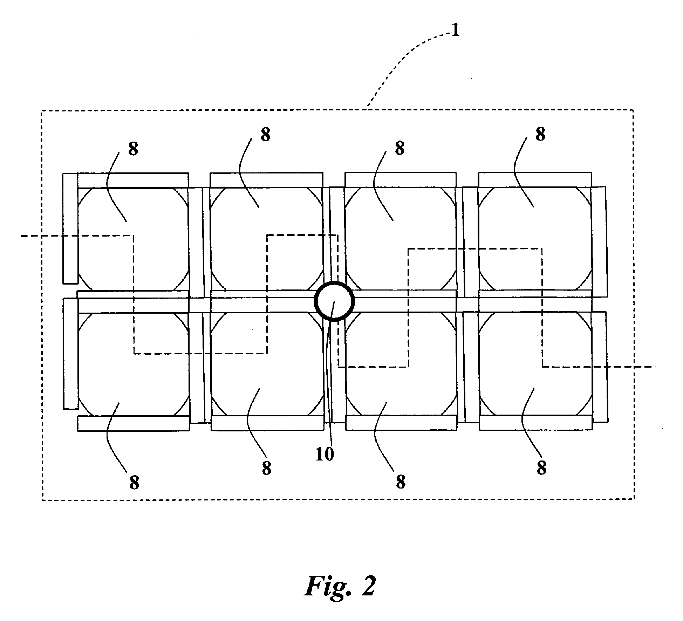

Figure 2 shows, for example, a second unit 10 integrated within a photovoltaic panel 1 so as to exclude any possibility of tampering therewith or removal thereof without damaging the panel. This characteristic can in any case be obtained by positioning the second unit 10 in such a way as to damage the panel if the latter is tampered with.

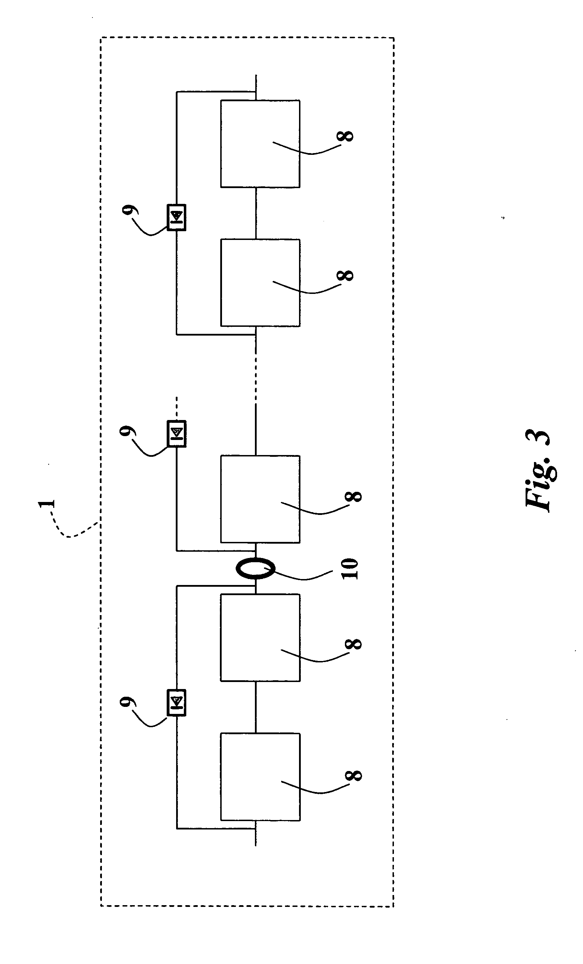

In Figures 2 and 3, it may be noted that each photovoltaic panel 1 comprises a plurality of photovoltaic cells, designated by the reference number 8, connected together in series.

Each photovoltaic cell 8 is obtained starting from a cylindrical bar of silicon with circular cross section. A thin lamina is obtained from the bar and is then cut so as to form a square cell with corners rounded off. This serves to optimize arrangement of the cells alongside one another within a panel so as to have the largest possible surface of the panel coated with cells.

With particular reference to Figure 3, in order to guarantee continuity of the electrical connection of the entire photovoltaic panel 1, by-pass diodes 9 are provided, connected in parallel to groups of cells connected in series. This serves to prevent the phenomena of obscuration due to the presence of leaves, insects, or objects that obscure a photovoltaic cell 8, rendering it in effect an open circuit.

In the examples illustrated in Figures 2 and 3, the second unit 10 is positioned so as not to be by-passed by the diodes 9.

In particular, the second unit 10 behaves as a whole as a short circuit when the switch 3 is closed, i.e., when the panel is connected to the plant and receives with pre-set cadence the activation code, and as an open circuit when the panel is disconnected from the plant. This behaviour is very advantageous during installation of the panels because it guarantees safety of the installers. The antitheft device functions hence also as a device for the protection of the person responsible for installation when the panels 1 are being installed.

The antitheft device is supplied by the photovoltaic panels that make up the plant. In the absence of sunlight it does not function. When the panels are illuminated by sunlight, the switch 3 conducts and the counter 2b starts counting. When the logic unit 2c of a panel 1 receives the activation code on the connection line L, it decodes it and, in the case of a positive result, resets the counter 2a, producing the first activation.

In particular, the second unit 10 behaves as an enabling switch that authorizes the respective photovoltaic panel 1 to produce current.

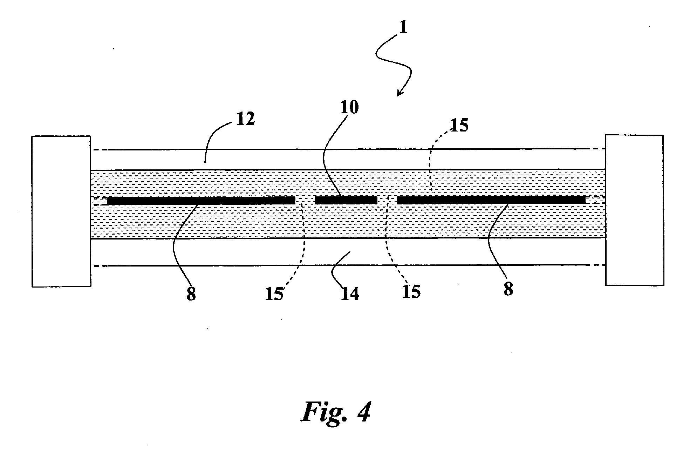

With particular reference to Figure 4, a photovoltaic panel 1 has a sandwich structure, with a bottom layer 14 made of sheet metal or glass, an intermediate layer 15 made of EVA (ethyl vinyl acetate) resin, which has the function of encapsulating the cells 8, as well as a function of ensuring adhesion between the cells 8, and a top layer 12 made of glass. The second unit 10 could, for example, be embedded in the intermediate layer made of EVA.

Since the first unit 11, which is usually well protected in a masonry structure or in the distribution substation, could be stolen together with the panels 1, it is necessary for it to be in turn protected with another type of antitheft device.

Starting from the photovoltaic plant described previously, in which each panel is equipped with a unit 10, which behaves as enabling switch that authorizes the respective photovoltaic panel 1 to produce current, with an appropriate management it is possible to detect the voltamperometric characteristics of each panel. The characteristics of operation of each panel, correlated to the insulation, can be used for driving the inverter. This enables surveillance of operation of each individual panel and maximization of the efficiency of the entire photovoltaic plant, moreover supplying a remote system with the operating information.

In particular, the same antitheft device can be used to activate/deactivate selectively each individual panel 1 and obtain a voltage/current characteristic to be used for the purposes of diagnostics (for identifying the panels in the plant that present a low efficiency and for intervening, for example, to clean or replace them).

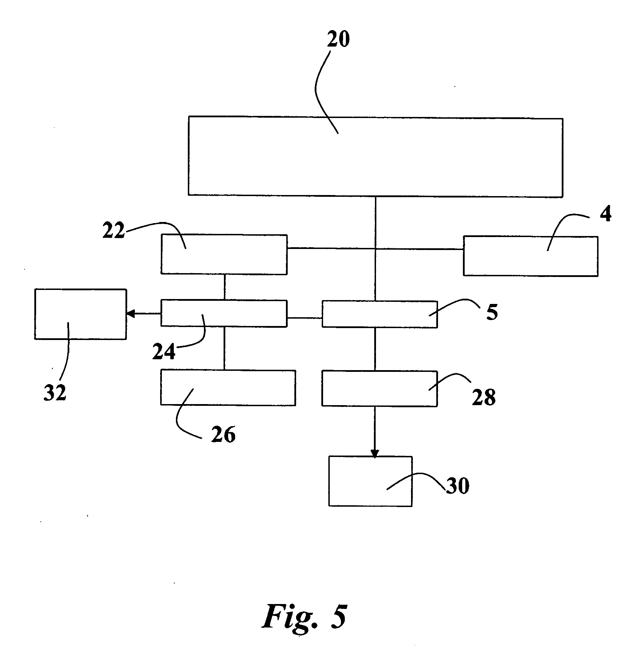

With reference to Figure 5, a field of photovoltaic panels is designated as a whole by the reference number 20. Each of the panels of the field 20 is equipped with a local unit, which, together with a central unit, forms the antitheft device described previously.

The monitoring system described herein is able to activate and/or deactivate selectively each individual photovoltaic panel 1 within the plant 20. To be able to do this, associated to each panel 1 is a unique activation code different from the activation code of the other panels. The activation code of each panel is stored in the corresponding memory element 2b present in the second unit 10, associated to the panel 1.

The code generator 4, set in the distribution substation 5, generates cyclically the different activation codes in order to activate/deactivate all the panels 1 selectively.

Under normal operating conditions, the code generator 4 generates cyclically all the activation codes and sends them with a given cadence onto the conductors of the connection line L. Each activation code activates a single panel 1, and the respective counter 2a starts its counting to mark out the wait time of sending of the next activation code. Hence, in the normal condition of operation, all the panels 1 are active and produce energy, which is sent to the network 30 through the inverter 5. Between the inverter 5 and the network 30 there exists a protection system 28, which has the purpose of connecting the photovoltaic plant 20 in a secure way to the network 30.

The protection system 28 comprises a BOS (Balance Of System) parameter that takes into account all the losses due to junctions, cables, connections, transformer or metering apparatuses, etc. If, for example, the BOS is 85% (which represents the average of what occurs in plants that do not present a particularly complex structure), it means that the overall losses of solar energy transformed into a.c. current amounts to 15%.

In this situation, if a panel 1 is removed from the plant 20, after a short time operation of said panel is inhibited in so far as the unit 10 does not receive the respective activation code. Hence, the antitheft function is maintained.

Before starting a monitoring session, the system deactivates all the panels 1 of the plant 20 by sending a particular deactivation code or else by waiting for the count of all the counters 2a to run out, without sending new activation codes.

Once all the panels 1 have been deactivated, the code generator 4 generates a single activation code and sends it onto the conductors of the connection line L, activating the corresponding panel 1, which starts to conduct and to produce energy. In this way, at that moment just one panel 1 is connected to the inverter 5.

The monitoring system moreover envisages a measuring device 22 for detecting the characteristics of the active panel, i.e., measuring the voltage and the current supplied by the individual panel 1 to the inverter 5.

The information gathered for each individual panel 1 is processed by a processor 24, which is able to detect an overall voltage/current characteristic. For instance, the overall characteristic of the entire field is represented by the sum of the characteristics of the individual panels 1.

To speed up scanning of monitoring of the entire plant, the monitoring system can send a deactivation signal to the active panel as soon as the operation of measuring performed by the device 22 is completed, without waiting for the cyclic time set by the corresponding counter 2a to elapse.

The processor 24 sends said characteristic to the inverter 5, which is able to optimize the efficiency of the photovoltaic field 20 by acting on the working point of the system, i.e., by varying the input impedance that the inverter 5 presents to the field 20.

There may moreover be present peripherals 32 connected to the processor 24 in order to enable interaction of the monitoring system with the operators.

In a preferred embodiment, there is moreover provided a photovoltaic sensor 26, which is oriented in the same way as the panels 1 and uses a photosensitive element identical to the one used by the panels themselves and serves to complete the information detected by providing a term of comparison. In particular, if at a certain instant the sun is clouded over, it is reasonable to expect a lower production of energy. The sensor 26 hence serves to identify these situations properly. Consequently, in such situations a low efficiency of a panel will be attributed to atmospheric causes and not to any malfunctioning of the panel itself, and no physical intervention will be required on the panel 1 in question.

Available for each system is a layout or a list, which, on the basis of the activation code, enables determination of the physical position of the individual panel within the plant. In this way, once it has been ascertained that a given panel presents problems (for example, a low efficiency) it is possible to physically intervene on the panel itself.

The activation code hence performs two different functions: one of protection, in so far as it serves as activation code for the antitheft system; and the other for unique identification of the panels for the monitoring system.

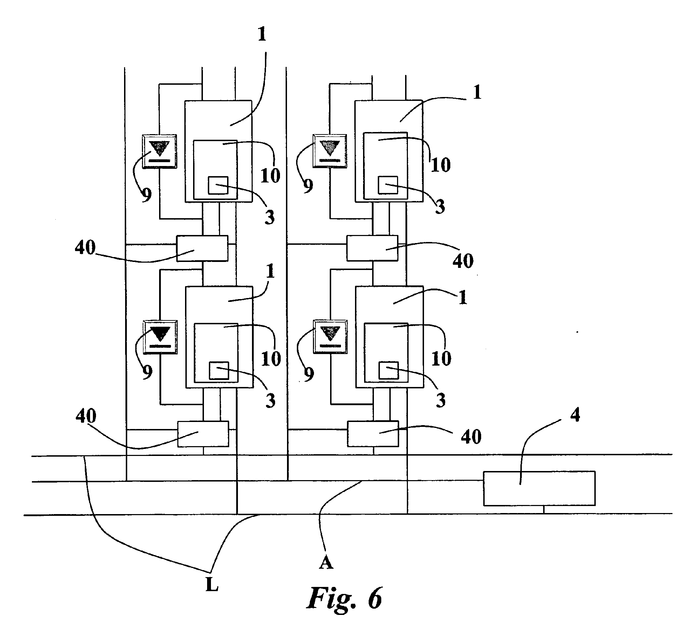

Represented in Figure 6 are two series of panels 1, connected in parallel with respect to the connection line L. In each series, the panels are instead connected together in series configuration. As may be seen from Figure 6, associated to each panel 1 is a by-pass diode 9, connected in parallel to the panel itself, which enables the current generated upstream of a panel to bypass said panel if it is inhibited or broken.

As already mentioned previously, each panel 1 contains inside it a unit 10 designed to block, via the switch 3, operation of the panel if it is not cyclically activated by the corresponding activation code transmitted on the connection line L. In some alternative embodiments, the activation codes can travel on a dedicated line A.

Set between the connection line L and each panel 1 is a junction box 40, through which the code transmitted by the unit 11 transits. In particular, with reference to Figure 1, the junction box 40 comprises the inductance 6, which serves to prevent the signal generated by the code generator 4 from propagating to the photovoltaic panel 1, and the capacitor 7, which has the purpose of bringing the high-frequency signal generated by the code generator 4 to the logic unit 2c.

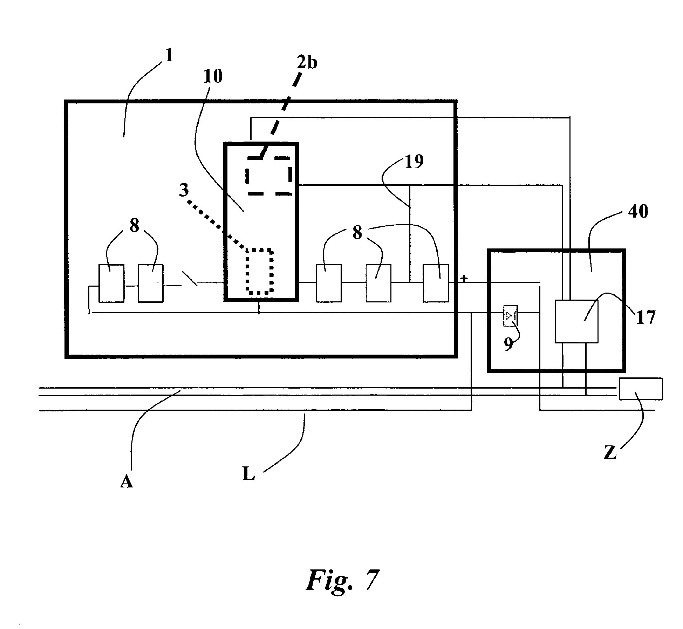

Illustrated in Figures 7 to 9 are three different embodiments of the monitoring system.

In Figures 7 to 9, parts, elements, or components that are identical or equivalent to parts, elements, or components already described with reference to the preceding Figures 1 to 6, are designated by the same references, which renders repetition of the corresponding description superfluous.

The junction box 40 can draw from the activation signal the energy that serves to supply the unit 10.

Furthermore, it may be envisaged to supply the unit 10 directly, via the line 19, within the panel 1, using the energy supplied by the cells 8. In this case, the cells 8 must be illuminated by sunlight or must receive energy from the junction box 40, which draws it from the signal that carries the activation code.

With reference to Figure 7, the activation signals can be transmitted on the dedicated line A (the line is closed on its characteristic impedance Z to prevent phenomena of reflection of the signal). In this particular case, within the junction box 40 there is a demodulator 17 with high-impedance input that has the purpose of demodulating the signal that arrives on the dedicated line A.

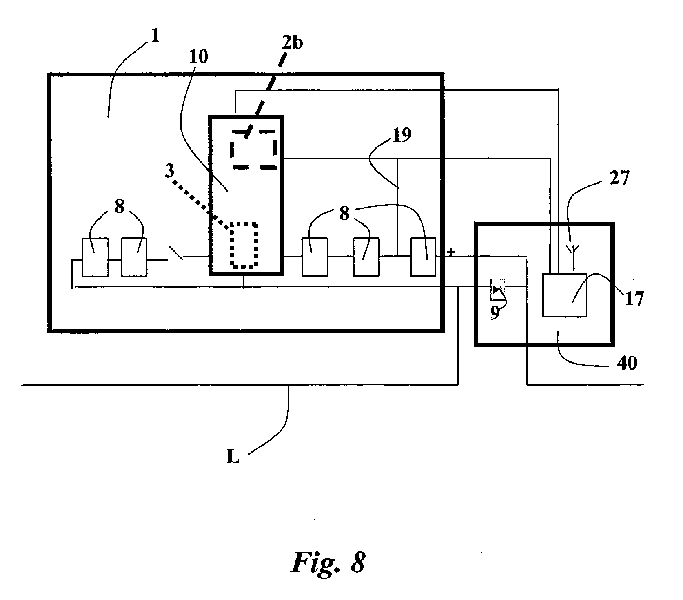

Alternatively, the activation signals can be transmitted via radio, as illustrated in Figure 8; in this case, the demodulator 17 receives the wireless signal through the antenna 27, and the supply of the circuits of the unit 10 must be drawn necessarily from the panel 1 through the line 19.

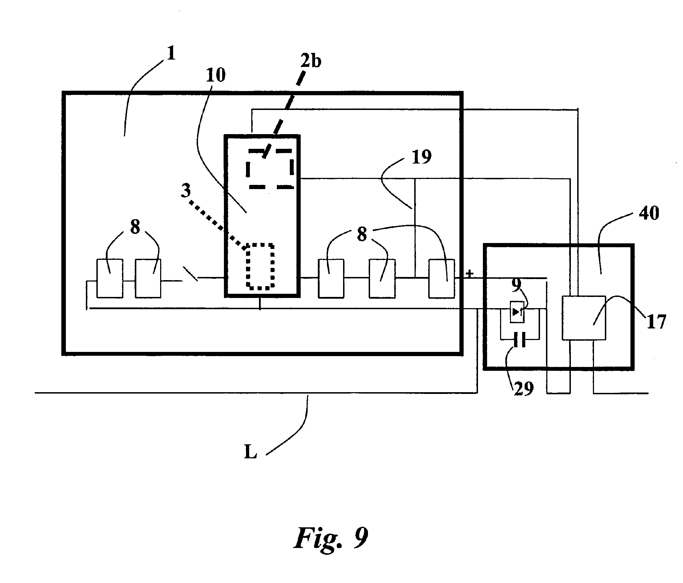

Finally, in Figure 9 the signal travels directly on the power line. In this case, the element 17 is a transformer that transfers the a.c. component freely and retrieves the information (i.e., the high-frequency signal). With this type of arrangement, it is necessary to envisage a capacitor 29 connected in parallel to the by-pass diode to enable passage of the high-frequency signal (at high frequencies the capacitor behaves as a short circuit).

It is moreover possible to envisage a monitoring system that functions in a conjugate way; i.e., it performs its monitoring function by deactivating a single panel at a time, to keep production of energy active.

The reference to "one embodiment" in the context of this description is intended to signify that a particular configuration, structure, or characteristic described in relation to the embodiment is comprised in at least one embodiment. Hence, phrases such as "in one embodiment" that may be present in various points of this description, do not necessarily refer to the same embodiment. Furthermore, particular conformations, structures, or characteristics can be combined adequately in one or more embodiments.

The references used herein are merely adopted for convenience and hence do not define the sphere of protection or the scope of the embodiments.

## Claims

1. An antitheft and monitoring system (10, 11) for a plurality of photovoltaic panels (1), wherein the panels (1) are connected by means of a connection line (L) to a distribution substation (5), the monitoring system (10, 11) comprising a first unit (11) associated to the distribution substation (5), wherein said first unit (11) is designed to generate activation codes (4), and a plurality of second units (10) associated to the panels (1), wherein each of said second units (10) is designed to inhibit operation of the respective panel (1) in the absence of the activation code (4) for a pre-set period, **characterised in that** each of the second units (10) is selectively activatable via a unique activation code (4) generated by said first unit (11).

2. The antitheft and monitoring system (10, 11) according to Claim 1, **characterized in that** said first unit (11) comprises a generator of activation codes (4), which generates a plurality of different activation codes and sends them with a pre-set cadence onto the connection line (L).

3. The antitheft and monitoring system (10, 11) according to Claim 2, **characterized in that** each of said second units (10) comprises:
- a memory element (2b), designed to store inside it a unique activation code (4) of the respective panel;
- a counter (2a), designed to count the wait time of the aforesaid unique activation code (4);
- a logic unit (2c), designed to process the activation code (4) present on the connection line (L) with the one stored in the memory element (2b), wherein said logic unit (2c) is configured for resetting the counter element (2a) in the case of positive outcome of the decoding operation; and
- a switch (3), governed by the logic unit (2c), designed to deactivate operation of the panel (1) when the counter element (2a) reaches a pre-set configuration.

4. The antitheft and monitoring system (10, 11) according to Claim 3, **characterized in that** the generator of activation codes (4) of the aforesaid first unit (11) is designed to generate a deactivation code, and **in that** the logic unit (2c) of each of the aforesaid second units (10) is designed to control opening of the corresponding switch (3) for deactivating operation of the panel (1) when it receives the aforesaid deactivation code.

5. The antitheft and monitoring system (10, 11) according to Claim 4, **characterized in that** it moreover comprises a measuring device (22) for detecting the characteristics of voltage and current of an individual active panel (1), and a processor module (24), designed to detect an overall characteristic starting from the characteristics of the individual panels (1), detected via the aforesaid measuring device (22) and to send the aforesaid overall characteristic to the distribution substation (5), and **in that** said distribution substation (5) varies its input impedance according to the aforesaid overall characteristic.

6. The antitheft and monitoring system (10, 11) according to Claim 5, **characterized in that** it moreover comprises a photovoltaic sensor (26), oriented to the same way as the panels (1) and with a photosensitive element identical to that of the panels (1) for supplying additional information regarding the atmospheric conditions of insulation.

7. The antitheft and monitoring system (10, 11) according to any one of the preceding Claims 3 to 6, **characterized in that**:
- said memory element (2b) is a ROM;
- said switch (3) is a FET; and
- each photovoltaic panel (1) comprises a plurality of photovoltaic cells (8) connected together in series, and said second unit (10) is set between two photovoltaic cells (8).

8. The antitheft and monitoring system according to Claim 7, **characterized in that** each photovoltaic panel (1) comprises a plurality of by-pass diodes (9) arranged in parallel to a plurality of photovoltaic cells (8), and **in that** each second unit (10) is positioned so as not to be by-passed by the by-pass diodes (9).

9. The antitheft and monitoring system according to any one of the preceding claims, **characterized in that** each second unit (10) of said plurality is supplied (19) by the respective photovoltaic panel.

10. The antitheft and monitoring system according to any one of the preceding claims, **characterized in that** the activation codes are transmitted:
- on a dedicated line (A) closed on its characteristic impedance (Z) to prevent phenomena of reflection;
- via radio; or
- directly on the connection line (L).

11. The antitheft and monitoring system according to any one of the preceding claims, **characterized in that** said distribution substation (5) comprises an inverter unit equipped with an antitheft device based upon GPS technology.

12. A procedure (10, 11) for monitoring a plurality of photovoltaic panels (1), wherein the panels (1) are connected by means of a connection line (L) to a distribution substation (5), the procedure envisaging the steps of:
- associating a first unit (11) to the distribution substation (5), wherein said first unit (11) is designed to generate activation codes (4); and
- associating to each panel (1) a second unit (10), wherein said second unit (10) is designed to inhibit operation of the respective panel (1) in the absence of the activation code (4) for a pre-set period, and wherein said second unit (10) is selectively activatable via a unique activation code (4) generated by said first unit (11).

13. The procedure according to Claim 11, **characterized in that** it moreover envisages the step of deactivating all the panels (1) by sending a deactivation code or interrupting generation and sending of the activation codes (4) for a given period of time.

14. The procedure according to Claim 12, **characterized in that** it moreover envisages the steps of:
- selectively activating an individual panel (1) by sending, on the connection line (L), the corresponding unique activation code (4); and
- detecting (22) the characteristics of voltage and current of the individual active panel (1).

15. The procedure according to Claim 13, **characterized in that** it moreover envisages the step of sending a deactivation signal for deactivating the individual active panel (1) at the end of the step of measurement of the characteristics of said individual active panel (1).

## Patentansprüche

1. Antidiebstahl- und Überwachungssystem (10, 11) für eine Mehrzahl von Photovoltaikpaneelen (1), wobei die Paneele (1) mit Hilfe einer Verbindungsleitung (L) mit einer Verteilungsunterstation (5) verbunden sind, wobei das Überwachungssystem (10, 11) eine erste Einheit (11) aufweist, welche der Verteilungsunterstation (5) zugeordnet ist, wobei die erste Einheit (11) ausgelegt ist Aktivierungscodes (4) zu erzeugen, und wobei das Überwachungssystem (10, 11) weiterhin eine Mehrzahl von zweiten Einheiten (10) aufweist, welche den Paneelen (1) zugeordnet sind, wobei jede der zweiten Einheiten (10) ausgelegt ist, den Betrieb des betreffenden Paneels (1) zu unterbinden, wenn der Aktivierungscode (4) für eine vordefinierte Zeitdauer ausbleibt,
**dadurch gekennzeichnet, dass**
jede der zweiten Einheiten (10) über einen eindeutigen Aktivierungscode (4), welcher von der ersten Einheit (11) erzeugt wird, selektiv aktivierbar ist.

2. Antidiebstahl- und Überwachungssystem (10, 11) gemäß Anspruch 1, **dadurch gekennzeichnet, dass** die erste Einheit (11) einen Generator von Aktivierungscodes (4) aufweist, der eine Mehrzahl von unterschiedlichen Aktivierungscodes erzeugt und diese in einem vordefinierten Rhythmus auf der Verbindungsleitung (L) sendet.

3. Antidiebstahl- und Überwachungssystem (10, 11) gemäß Anspruch 2, **dadurch gekennzeichnet, dass** jede der zweiten Einheiten (10) aufweist:
- Ein Speicherelement (2b), welches ausgelegt ist, in sich einen eindeutigen Aktivierungscode (4) des betreffenden Paneels zu speichern;
- Ein Zähler (2a), welcher ausgelegt ist, die Wartezeit des oben erwähnten eindeutigen Aktivierungscodes (4) zu zählen;
- Eine logische Einheit (2c), welche ausgelegt ist, den auf der Verbindungsleitung (L) vorhandenen Aktivierungscode (4), zusammen mit demjenigen, welcher im Speicherelement (2b) gespeichert ist, zu verarbeiten, wobei die logische Einheit (2c) so konfiguriert ist, dass sie das Zählerelement (2a) zurücksetzt im Falle eines positiven Ergebnisses des Decodierungsvorgangs; und
- Ein Schalter (3), welcher von der logischen Einheit (2c) angesteuert wird und welcher dafür ausgelegt ist, den Betrieb des Paneels (1) zu deaktivieren, wenn das Zählerelement (2a) eine vordefinierte Konfiguration erreicht.

4. Antidiebstahl- und Überwachungssystem (10, 11) gemäß Anspruch 3, **dadurch gekennzeichnet, dass** der Generator von Aktivierungscodes (4) der oben erwähnten ersten Einheit (11) dafür ausgelegt ist, einen Deaktivierungscode zu erzeugen, und **dadurch gekennzeichnet, dass** die logische Einheit (2c) von jeder der oben erwähnten zweiten Einheiten (10) dafür ausgelegt ist, das Öffnen des zugehörigen Schalters (3) zu steuern, um den Betrieb des Paneels (1) zu deaktivieren, wenn sie den oben erwähnten Deaktivierungscode empfängt.

5. Antidiebstahl- und Überwachungssystem (10, 11) gemäß Anspruch 4, **dadurch gekennzeichnet, dass** es darüber hinaus eine Messeinrichtung (22) zur Bestimmung der Kenndaten von Spannung und Strom eines individuellen aktiven Paneels (1) sowie ein Prozessormodul (24) aufweist, welches dafür ausgelegt ist, eine Gesamtcharakteristik ausgehend von den Kenndaten der individuellen Paneele (1) zu bestimmen, welche über die oben erwähnte Messeinrichtung (22) ermittelt wurden, und die oben erwähnte Gesamtcharakteristik an die Verteilungsunterstation (5) zu senden, sowie **dadurch gekennzeichnet, dass** die Verteilungsunterstation (5) ihre Eingangsimpedanz entsprechend der oben erwähnten Gesamtcharakteristik verändert.

6. Antidiebstahl- und Überwachungssystem (10, 11) gemäß Anspruch 5, **dadurch gekennzeichnet, dass** es darüber hinaus einen Photovoltaik-Sensor (26) aufweist, welcher in der selben Richtung wie die Paneele (1) ausgerichtet ist und der mit einem photosensitiven Element ausgestattet ist, welches zu denen der Paneele (1) identisch ist, um zusätzliche Informationen bezüglich der atmosphärischen Dämpfungsbedingungen bereitzustellen.

7. Antidiebstahl- und Überwachungssystem (10, 11) gemäß einem der Ansprüche 3 bis 6, **dadurch gekennzeichnet, dass**:
- Das Speicherelement (2b) ein ROM ist;
- Der Schalter (3) ein FET ist; und
- Jedes Photovoltaikpaneel (1) eine Mehrzahl von Photovoltaikzellen (8) aufweist, welche miteinander in Serie verbunden sind, und die zweite Einheit (10) zwischen zwei Photovoltaikzellen (8) angeordnet ist.

8. Antidiebstahl- und Überwachungssystem gemäß Anspruch 7, **dadurch gekennzeichnet, dass** jedes Photovoltaikpaneel (1) eine Mehrzahl von Bypass-Dioden (9) aufweist, welche parallel zu einer Mehrzahl von Photovoltaikzellen (8) angeordnet sind, und **dadurch gekennzeichnet, dass** jede zweite Einheit (10) so angeordnet ist, dass sie nicht von den Bypass-Dioden (9) umgangen wird.

9. Antidiebstahl- und Überwachungssystem gemäß einem der vorangegangenen Ansprüche, **dadurch gekennzeichnet, dass** jede zweite Einheit (10) aus der Mehrzahl der zweiten Einheiten (10) durch das dazugehörige Photovoltaikpaneel versorgt (19) wird.

10. Antidiebstahl- und Überwachungssystem gemäß einem der vorangegangenen Ansprüche, **dadurch gekennzeichnet, dass** die Aktivierungscodes übermittelt werden:
- Auf einer speziellen Leitung (A) abgeschlossen durch ihre charakteristische Impedanz (Z), um das Phänomen der Reflektion zu verhindern;
- Über Funk; oder
- Direkt über die Anschlussleitung (L).

11. Antidiebstahl- und Überwachungssystem gemäß einem der vorangegangenen Ansprüche, **dadurch gekennzeichnet, dass** die Verteilungsunterstation (5) eine Inverter-Einheit aufweist, die mit einer Diebstahlsicherung basierend auf GPS-Technologie ausgestattet ist.

12. Verfahren (10, 11) zum Überwachen einer Mehrzahl von Photovoltaikpaneelen (1), wobei die Paneele (1) mithilfe einer Verbindungsleitung (L) mit einer Verteilungsunterstation (5) verbunden sind und das Verfahren die folgenden Schritte aufweist:
- Zuordnen einer ersten Einheit (11) zu der Verteilungsunterstation (5), wobei die erste Einheit (11) dafür ausgelegt ist Aktivierungscodes (4) zu erzeugen; und
- Zuordnen einer zweiten Einheit (10) zu jedem Paneel (1), wobei die zweite Einheit (10) dafür ausgelegt ist, den Betrieb des betreffenden Paneels (1) zu deaktivieren, wenn der Aktivierungscode (4) für eine vordefinierte Zeitdauer ausbleibt, und wobei die zweite Einheit (10) selektiv über einen eindeutigen Aktivierungscode (4), welcher von der ersten Einheit (11) erzeugt wird, aktivierbar ist.

13. Verfahren gemäß Anspruch 11, **dadurch gekennzeichnet, dass** es weiterhin den Schritt des Deaktivierens aller Paneele (1) vorsieht durch Senden eines Deaktivierungscodes oder durch Unterbrechen der Erzeugung und des Sendens der Aktivierungscodes (4) für eine gegebene Zeitspanne.

14. Verfahren gemäß Anspruch 12, **dadurch gekennzeichnet, dass** es weiterhin die folgenden Schritte vorsieht:
- Selektives Aktivieren eines individuellen Paneels (1) durch Senden des eindeutigen zugehörigen Aktivierungscodes (4) auf der Verbindungsleitung (L); und
- Erfassen (22) der Kenndaten von Spannung und Strom des individuellen, aktiven Paneels (1).

15. Verfahren gemäß Anspruch 13, **dadurch gekennzeichnet, dass** es weiterhin den Schritt des Sendens eines Deaktivierungssignals vorsieht zum Deaktivieren des individuellen, aktiven Paneels (1) am Ende des Schritts des Messens der Kenndaten des individuellen, aktiven Paneels (1).

## Revendications

1. Système de surveillance et de protection contre le vol (10, 11) destiné à une pluralité de panneaux photovoltaïques (1), dans lequel les panneaux (1) sont connectés au moyen d'une ligne de connexion (L) à une sous-station de distribution (5), le système de surveillance (10, 11) comprenant une première unité (11) associée à la sous-station de distribution (5), dans laquelle ladite première unité (11) est conçue de manière à générer des codes d'activation (4), et une pluralité de secondes unités (10) associées aux panneaux (1), dans lesquelles chacune desdites secondes unités (10) est conçue de manière à bloquer le fonctionnement du panneau respectif (1) en l'absence du code d'activation (4) pendant une période de temps prédéfinie, **caractérisé en ce que** chacune des secondes unités (10) est activable de manière sélective via un code d'activation unique (4) généré par ladite première unité (11).

2. Système de surveillance et de protection contre le vol (10, 11) selon la revendication 1, **caractérisé en ce que** ladite première unité (11) comprend un générateur de codes d'activation (4), lequel génère une pluralité de codes d'activation distincts et les envoie à une cadence prédéfinie sur la ligne de connexion (L).

3. Système de surveillance et de protection contre le vol (10, 11) selon la revendication 2, **caractérisé en ce que** chacune desdites secondes unités (10) comprend :
- un élément de mémoire (2b) conçu de manière à stocker en interne un code d'activation unique (4) du panneau respectif ;
- un compteur (2a) conçu de manière à compter le temps d'attente du code d'activation unique précité (4) ;
- une unité logique (2c) conçue de manière à traiter le code d'activation (4) présent sur la ligne de connexion (L) avec celui stocké dans l'élément de mémoire (2b), dans laquelle ladite unité logique (2c) est configurée de manière à réinitialiser l'élément de compteur (2a) dans le cas d'un résultat positif de l'opération de décodage ; et
- un commutateur (3), régi par l'unité logique (2c), conçu de manière à désactiver le fonctionnement du panneau (1) lorsque l'élément de compteur (2a) atteint une configuration prédéfinie.

4. Système de surveillance et de protection contre le vol (10, 11) selon la revendication 3, **caractérisé en ce que** le générateur de codes d'activation (4) de la première unité précitée (11) est conçu de manière à générer un code de désactivation, et **en ce que** l'unité logique (2c) de chacune des secondes unités précitées (10) est conçue de manière à commander l'ouverture du commutateur correspondant (3) en vue de désactiver le fonctionnement du panneau (1) lorsqu'elle reçoit le code de désactivation précité.

5. Système de surveillance et de protection contre le vol (10, 11) selon la revendication 4, **caractérisé en ce qu'**il comporte en outre un dispositif de mesure (22) pour détecter les caractéristiques de tension et de courant d'un panneau actif individuel (1), et un module de processeur (24) conçu de manière à détecter une caractéristique globale à partir des caractéristiques des panneaux individuels (1), détectée via le dispositif de mesure précité (22), et à envoyer la caractéristique globale précitée à la sous-station de distribution (5), et **en ce que** ladite sous-station de distribution (5) modifie son impédance d'entrée selon la caractéristique globale précitée.

6. Système de surveillance et de protection contre le vol (10, 11) selon la revendication 5, **caractérisé en ce qu'**il comporte en outre un capteur photovoltaïque (26), orienté de la même manière que les panneaux (1) et présentant un élément photosensible identique à celui des panneaux (1), pour fournir des informations supplémentaires concernant les conditions atmosphériques d'isolation.

7. Système de surveillance et de protection contre le vol (10, 11) selon l'une quelconque des revendications 3 à 6, **caractérisé en ce que** :
- ledit élément de mémoire (2b) est une mémoire morte (ROM) ;
- ledit commutateur (3) est un transistor à effet de champ (FET) ; et
- chaque panneau photovoltaïque (1) comporte une pluralité de cellules photovoltaïques (8) mutuellement connectées en série, et **en ce que** ladite seconde unité (10) est fixée entre deux cellules photovoltaïques (8).

8. Système de surveillance et de protection contre le vol selon la revendication 7, **caractérisé en ce que** chaque panneau photovoltaïque (1) comporte une pluralité de diodes de dérivation (9) agencées en parallèle à une pluralité de cellules photovoltaïques (8), et **en ce que** chaque seconde unité (10) est positionnée afin de ne pas être court-circuitée par les diodes de dérivation (9).

9. Système de surveillance et de protection contre le vol selon l'une quelconque des revendications précédentes, **caractérisé en ce que** chaque seconde unité (10) de ladite pluralité est fournie (19) par le panneau photovoltaïque respectif.

10. Système de surveillance et de protection contre le vol selon l'une quelconque des revendications précédentes, **caractérisé en ce que** les codes d'activation sont transmis :
- sur une ligne dédiée (A) dont l'impédance caractéristique est fermée (Z) pour éviter les phénomènes de réflexion ;
- par voie hertzienne ; ou
- directement sur la ligne de connexion (L).

11. Système de surveillance et de protection contre le vol selon l'une quelconque des revendications précédentes, **caractérisé en ce que** ladite sous-station de distribution (5) comprend un onduleur équipé d'un dispositif antivol basé sur la technologie GPS.

12. Procédé (10, 11) destiné à surveiller une pluralité de panneaux photovoltaïques (1), dans lequel les panneaux (1) sont connectés au moyen d'une ligne de connexion (L) à une sous-station de distribution (5), le procédé comportant les étapes ci-dessous consistant à :
- associer une première unité (11) à la sous-station de distribution (5), dans laquelle ladite première unité (11) est conçue de manière à générer des codes d'activation (4) ; et
- associer, à chaque panneau (1), une seconde unité (10), dans laquelle ladite seconde unité (10) est conçue de manière à bloquer le fonctionnement du panneau respectif (1) en l'absence du code d'activation (4) pendant une période de temps prédéfinie, et dans laquelle ladite seconde unité (10) est activable de manière sélective via un code d'activation unique (4) généré par ladite première unité (11).

13. Procédé selon la revendication 11, **caractérisé en ce qu'**il prévoit en outre l'étape consistant à désactiver tous les panneaux (1) en envoyant un code de désactivation ou interrompre la génération et l'envoi des codes d'activation (4) pour une période de temps donnée.

14. Procédé selon la revendication 12, **caractérisé en ce qu'**il prévoit en outre les étapes ci-dessous consistant à :
- activer de manière sélective un panneau individuel (1) en envoyant, sur la ligne de connexion (L), le code d'activation unique correspondant (4) ; et
- détecter (22) les caractéristiques de tension et de courant du panneau actif individuel (1).

15. Procédé selon la revendication 13, **caractérisé en ce qu'**il prévoit en outre l'étape consistant à envoyer un signal de désactivation en vue de désactiver le panneau actif individuel (1) à l'issue de l'étape de mesure des caractéristiques dudit panneau actif individuel (1).
